# EUROPÄISCHE PATENTSCHRIFT

(11) **EP 1 188 236 B1**
(45) Veröffentlichungstag und Bekanntmachung des Hinweises auf die Patenterteilung: **30.07.2003**
(21) Anmeldenummer: 00945559.3
(22) Anmeldetag: 23.05.2000
(51) Int. Cl.: H03J 1/00

(54) **INTEGRIERTE SCHALTUNG ZUR DETEKTION EINES EMPFANGSSIGNALS SOWIE SCHALTUNGSANORDNUNG**
INTEGRATED CIRCUIT FOR DETECTING A RECEIVE SIGNAL AND CIRCUIT ARRAY
CIRCUIT INTEGRE POUR LA DETECTION D'UN SIGNAL DE RECEPTION ET ENSEMBLE CIRCUIT CORRESPONDANT

(30) Priorität: 23.06.1999 DE 19928794
(43) Veröffentlichungstag der Anmeldung: 20.03.2002
(73) Patentinhaber: Infineon Technologies AG, 81669 München (DE)
(72) Erfinder: STEPP, Richard, D-80796 München (DE); KRÖBEL, Hans-Eberhard, D-81735 München (DE)
(74) Vertreter: Epping Hermann & Fischer
(86) Internationale Anmeldenummer: DE0001644
(87) Internationale Veröffentlichungsnummer: WO01001572

(56) Entgegenhaltungen:
- EP-A- 0 335 141
- EP-A- 0 415 610
- EP-A- 0 430 469
- EP-A- 0 788 226
- PATENT ABSTRACTS OF JAPAN vol. 009, no. 248 (E-347), 4. Oktober 1985 (1985-10-04) & JP 60 096913 A (PIONEER KK), 30. Mai 1985 (1985-05-30)

## Beschreibung

Die Erfindung betrifft eine integrierte Schaltung zur Detektion eines Empfangssignals, die beispielsweise in Rundfunkempfängern und insbesondere in mobilen Rundfunkempfängern Verwendung finden kann sowie eine Schaltungsanordnung mit einer integrierten Schaltung.

In der Rundfunk-Empfangstechnik haben sich mit einer Phasenregelschleife (Phase Locked Loop PLL) abgestimmte spannungsgesteuerte Oszillatoren, auch Voltage Controlled Oscillator (VCO) genannt, etabliert. Der spannungsgesteuerte Oszillator wird mit Hilfe der Phasenregelschleife mit einer bestimmten Schrittweite, beim frequenzmodulierten Rundfunk in Europa mit einer Frequenzschrittweite von 100 KHz, in seiner Oszillatorfrequenz abgestimmt. Beim Sendersuchlauf wird das gesamte FM-Band (87,5 MHz bis 108 MHz) vorzugsweise in 100 KHz Schritten abgescannt. Die Frequenz des spannungsgesteuerten Oszillators fOsz liegt typischerweise um 10,7 MHz über der zu empfangenden Eingangsfrequenz, also zwischen 98,2 MHz und 118,7 MHz.

Beim Sendersuchlauf sollen möglichst alle empfangswürdigen Sender gefunden und deren Eingangsfrequenz oder die entsprechende Oszillatorfrequenz fOsz des spannungsgestueerten Oszillators abgespeichert werden. Wird bei einer beliebigen Empfangsfrequenz ein Sender detektiert, so wird die Phasenregelschleife durch den Mikrocontroller auf dem aktuellen Wert angehalten. Die entsprechenden Werte werden im Mikrocontroller abgelegt, so daß zu einem späteren Zeitpunkt diese ermittelten Senderstationen direkt eingestellt werden können. Um die Sendestationen detektieren zu können, benötigt man ein oder - zur erhöhten Detektionsgenauigkeit - mehrere Kriterien, um den spannungsgesteuerten Oszillator bei der entsprechenden Oszillatorfrequenz zu stoppen. Im Empfänger müssen also eine oder besser mehrere Auswertekriterien benutzt werden, um eineindeutig das Vorhandensein eines empfangswürdigen Eingangssignals zu detektieren.

Zur Erhöhung der Sicherheit mit der ein Sender eindeutig erkannt werden kann, kann neben dem Feldstärkesignal (Pegel des Empfangssignals) zusätzlich das Multipathsignal, das anzeigt ob das Empfangssignal durch einen Mehrwegeempfang gestreut ist, herangezogen werden. Dazu werden das Feldstärkesignal und das Multipathsignal einem Mikroprozessor zugeführt, der diese Signale digitalisiert und anhand von im Mikroprozessor vorgegebenen Kriterien bewertet. Letztendlich wird im Mikroprozessor entschieden, ob es sich um einen empfangswürdigen Sender handelt. Eine derartige Schaltungsanordnung hat zum Nachteil, daß mehrere Leitungen vom Empfängerbaustein zum Mikroprozessor benötigt werden und während des Sendersuchlaufes ein unvermeidbarer Datenverkehr auf dem Datenbus stattfindet. Dadurch wird aber nicht nur der Mikroprozessor unnötig stark belastet, der Datenverkehr stellt auch eine permanente Störquelle im empfindlichen Empfangssystem dar. Um den Datenverkehr möglichst gering zu halten, wird deshalb häufig auf die Einbeziehung des Sendersuchkriteriums der Zwischenfrequenzzählung verzichtet, was jedoch den Nachteil einer ungenaueren Sendererkennung zur Folge hat. Für einen sicheren Suchlaufstopp genügt es in vielen Fällen nicht, nur eines der Suchlaufstoppkriterien Feldstärkesignal, Multipathsignal, Nulldurchgang der S-Kurve und die aus dem Eingangsmischer im Zwischenfrequenzverstärker begrenzte Zwischenfrequenz, auszuwerten. Es ist schwierig, schwach empfangbare Sender lediglich über die Feldstärke sicher erkennen zu können.

In der EP-A2-0 430 469 ist eine Schaltung zur Detektion eines Empfangssignals für FM-Empfänger gezeigt. Der Detektor enthält einen Zwischenfrequenzdetektor, einen Feldstärkekomparator und einen Rauschsignaldetektor, deren Ausgangssignale in einem logischen Schaltglied miteinander zu einem Signalpfad kombiniert werden. Davon abhängig wird ein Mikroprozessor angesteuert.

In Patent Abstracts of Japan, Band 009, Nr. 248 (E-347), 4. Oktober 1985 (JP-A-60-096913) ist beschrieben, einen Rauschdetektor zur Detektion von Rauschen aufgrund von Multipath-Signalen zu verwenden.

Schließlich ist in der EP-A2-0 335 141 eine Anordnung zur Detektion verschiedener Empfangskenngrößen einschließlich eines Mehrwege-Empfangs gezeigt, deren Ausgänge mit einem logischen Verknüpfungsglied gekoppelt sind.

Eine Aufgabe der Erfindung ist es, eine integrierte Schaltung zur Detektion eines Empfangssignals anzugeben, die eine möglichst schnelle und sichere Sendererkennung unter Vermeidung von Störungen ermöglicht.

Die Aufgabe wird durch eine integrierte Schaltung zur Detektion eines Empfangssignals mit den Merkmalen gemäß Patentanspruch 1 gelöst.

Gegenüber dem Dokument EP-A2-0 430 469 unterscheidet die integrierte Schaltung zur Detektion eines Empfangssignals gemäß Patentanspruch 1 der vorliegenden Anmeldung dadurch, daß Digital-Analog-Wandler sowie Seriell-Parallel-Umsetzer vorgesehen sind, die den jeweiligen Feldstärke- und Multipathkomparatoren vorgeschaltet sind.

Die erfindungsgemäße integrierte Schaltung zur Detektion eines Empfangssignal weist einen Zwischenfrequenzdetektor auf, der, falls die Zwischenfrequenz innerhalb eines bestimmten Bereichs liegt, ein erstes Suchlaufstoppsignal liefert. Weiterhin weist die integrierte Schaltung einen Feldstärkekomparator auf, der, falls die Feldstärke des Empfangssignals einen Feldstärkesollwert überschreitet, ein zweites Suchlaufstoppsignal liefert. Die Erfindung weist zusätzlich einen Multipathkomparator auf der, falls das Multipathsignal einen bestimmten Multipathsollwert überschreitet, ein drittes Suchlaufstoppsignal liefert. Weiterhin ist eine Verknüpfungseinrichtung vorgesehen, die die drei Suchlaufstoppsignale logisch miteinander zu einem binären Stoppsignal verknüpft, welches statisch am Ausgang der Verknüpfungseinrichtung anliegt und einem Mikroprozessor als dessen Eingangssignal zur Verfügung steht.

Der Datenverkehr zwischen dem Mikroprozessor und der integrierten Schaltung wird reduziert, was eine starke Reduktion der Störungen zur Folge hat.

Die integrierte Schaltung hat den Vorteil, daß durch die Integration eines ersten Analog-Digital-Wandlers, der dem Feldstärkekomparator vorgeschaltet ist und zur Digitalisierung des Feldstärkesignals dient, in die integrierte Schaltung der Gesamtflächenbedarf für den Rundfunkempfänger reduziert werden kann. Ebenso sind die externen, also außerhalb der integrierten Schaltung verlaufenden elektrischen Leitungen dadurch reduzierbar, was die Störanfälligkeit ebenfalls reduziert.

Ein dem Multipathkomparator vorgeschalteter zweiter Analog-Digital-Wandler, der zur Digitalisierung des Multipathsignals dient, bringt ebenfalls die genannten Vorteile mit sich.

Die integrierte Schaltung hat den Vorteil, daß durch einen zwischen dem ersten Analog-Digital-Wandler und dem Feldstärkekomparator geschalteten ersten Seriell-Parallel-Umsetzer eine beschleunigte Signalverarbeitung im Feldstärkekomparator möglich ist.

Dieser Vorteil gilt auch dafür, daß ein zweiter Seriell-Parallel-Umsetzer zwischen dem zweiten Analog-Digital-Wandler und dem Multipathkomparator geschaltet ist.

Weitere vorteilhafte Ausgestaltungen der erfindungsgemäßen integrierten Schaltung sind in den abhängigen Patentansprüchen angegeben.

Vorteilhafterweise kann die erfindungsgemäße integrierte Schaltung gemäß Patentanspruch 2 dadurch, daß der Feldstärkesollwert und der Multipathsollwert in empfangsschwachen Gebieten auf niedrigere Werte als in empfangsstarken Gebieten gesetzt werden, an die Umgebungsbedingungen angepaßt werden, so daß nach wie vor eine schnelle Sendersignalerkennung möglich ist.

Bei einer vorteilhaften Ausgestaltung der integrierten Schaltung gemäß Patentanspruch 3 erfolgt die Bestimmung des Feldstärkesollwerts, des Multipathsollwerts und des Bereichs, innerhalb dessen die Zwischenfrequenz liegen soll, durch den Mikroprozessor. Dadurch ist eine flexible, schnelle und einfache Anpassung der Sollwerte an die Umgebungsbedingungen möglich, ohne daß die Rechenkapazität des Mikroprozessors dadurch nennenswert eingeschränkt wird.

Erfindungsgemäß wird die auf eine Schaltungsanordnung gerichtete Aufgabe, durch eine Schaltungsanordnung gelöst, die eine integrierte Schaltung und einen Mikroprozessor umfaßt, bei der die integrierte Schaltung einen Ausgangsanschluß für das binäre Stopsignal aufweist, der mit einem eine einzige Leitung umfassenden Eingangsanschluß des Mikroprozessors verbunden ist und bei der der Mikroprozessor mindestens einen Ausgangsanschluß aufweist, der mit mindestens einem Eingangsanschluß der integrierten Schaltung verbunden ist, um darüber den Feldstärkesollwert und den Multipathsignalwert als serielles Datenwort und den Bereich, innerhalb dessen die Zwischenfrequenz liegen soll, zu übertragen.

Die Erfindung wird im folgenden anhand einer Figur weiter erläutert.

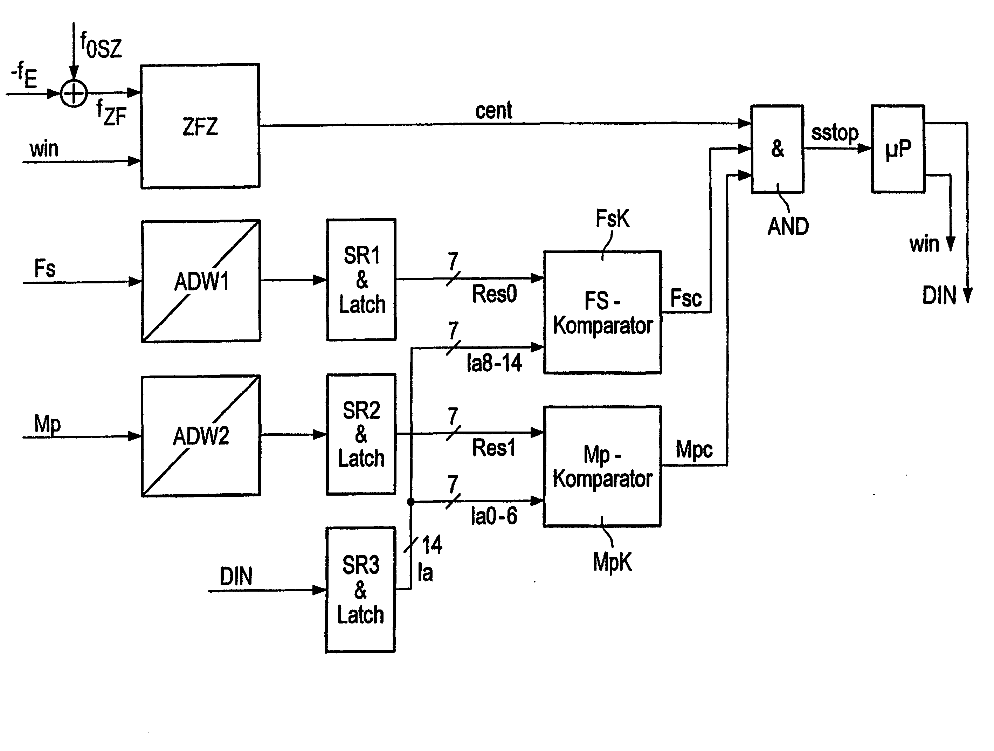

Die Figur zeigt ein Blockdiagramm einer möglichen Ausgestaltung der Erfindung, welches die wesentlichen Komponenten für den Sendersuchlauf enthält. Ein Zwischenfrequenz-Zähler ZFZ dient zur Detektion, ob die am Zwischenfrequenz-Zähler ZFZ anliegende Zwischenfrequenz fZF, welche die Differenz aus der Oszillatorfrequenz fOsz und der Empfangsfrequenz fE des Empfangssignals ist, innerhalb eines vorgegebenen Bereichs win liegt. Der Bereich win stellt einen Sollwert dar, der abhängig von der gewünschten Genauigkeit beispielsweise durch den Mikroprozessor µP vorgegeben werden kann. Durch den Bereich win wird festgelegt, innerhalb welchen Bereichs die Zwischenfrequenz fZF liegen darf, um als zu einem Sender gehöriges Sendesignal erkannt zu werden.

Am Ausgang des Zwischenfrequenz-Zählers ZFZ liegt ein erstes Suchlaufstoppsignal cent an, das zwei verschiedene logische Zustände aufweisen kann. Ein Suchlaufstoppsignal cent mit einem ersten logischen Zustand gibt an, daß eine Zwischenfrequenz fZF innerhalb des Bereichs win detektiert wurde, wohingegen das Suchlaufstoppsignal cent mit dem zweiten logischen Zustand anzeigt, daß innerhalb dieses Bereichs win keine Zwischenfrequenz fZF detektiert wurde.

Neben der Zwischenfrequenzdetektion zur Sendererkennung ist ein Feldstärkekomparator FsK als zweites Kriterium zur Detektion eines Empfangssignals vorgesehen. Der Feldstärkekomparator FsK vergleicht das durch einen ersten Analog-Digital-Wandler ADW1 digitalisierte Feldstärkesignal Fs, welches anschließend in ein 7 Bit breites Datenwort Res0 gewandelt wurde, mit einem ebenfalls 7 Bit breiten Feldstärkesollwert la8-14. Die Umsetzung des seriellen Datenworts in das parallele 7 Bit breite Datenwort Res0 erfolgt durch den ersten Seriell-Parallel-Umsetzer SR1, welcher ein Schieberegister und ein Latch aufweist. Am Ausgang des Feldstärkekomperators FsK ist ein zweites Suchlaufstoppsignal Fsc abgreifbar, daß ebenfalls wie das erste Suchlaufstoppsignal cent zwei logische Zustände aufweisen kann. Weist das zweite Suchlaufstoppsignal Fsc einen ersten logischen Zustand auf, so bedeutet dies, daß der Feldstärkekomperator FsK ein Empfangssignal detektiert hat, wohingegen wenn das zweite Suchlaufstoppsignal Fsc den zweiten logischen Zustand annimmt, durch den Feldstärkekomperator FsK kein Empfangssignal detektiert wurde.

Als drittes Kriterium zur Detektion des Empfangssignals ist ein Multipathkomparator MpK vorgesehen, der das durch den zweiten Analog-Digital-Wandler ADW2 digitalisierte Multipathsignal Mp, welches dem Multipathkomparator MpK als 7 Bit breites Datenwort Res1 zugeführt wird, mit einem Multipathsollwert la0-6 vergleicht. Die Umsetzung des digitalisierten Multipathsignals Mp erfolgt durch einen zweiten Seriell-Parallel-Umsetzer SR2, welcher zwischen den zweiten Analog-Digital-Wandler ADW2 und den Multipathkomparator MpK geschaltet ist. Auch das vom Multipathkomparator MpK erzeugte dritte Suchlaufstoppsignal Mpc kann zwei logische Zustände aufweisen, wobei im ersten logischen Zustand vom Multipathkomparator MpK ein Empfangssignal detektiert wurde. Für den Fall, daß das dritte Suchlaufstoppsignal Mpc den zweiten logischen Zustand annimmt, wurde durch den Multipathkomparator MpK kein Empfangssignal detektiert.

Der Multipathsollwert und der Feldstärkesollwert werden zusammen als serielles Datenwort DIN in einen dritten Seriellparallel-Umsetzer SR3 eingelesen und als 14 Bit breites Datenwort la am Ausgang des dritten Seriell-Parallel-Umsetzers SR3 ausgegeben. Die ersten 7 Bit des Datenworts la werden dabei als Multipathsollwert la0-6 dem Multipathkomparator MpK und die zweiten 7 Bits als Feldstärkesollwert la8-14 dem Feldstärkekomperator FsK zur Verfügung gestellt.

Die drei Suchlaufstoppsignale cent, Fsc und Mpc werden durch ein UND-Gatter AND logisch miteinander verknüpft und ergeben am Ausgang des UND-Gatters AND ein Stoppsignal sstop, welches das Eingangssignal für den Mikroprozessor µP darstellt. Das Stoppsignal sstop kann dabei zwei logische Zustände annehmen. Im ersten logischen Zustand wurde jeweils von dem Zwischenfrequenz-Zähler ZFZ, dem Feldstärkekomperator FsK und dem Multipathkomparator MpK ein Empfangssignal detektiert. Nimmt das Stoppsignal sstop den zweiten logischen Zustand an, so wurde durch eine der drei Komponenten Zwischenfrequenz-Zähler ZFZ, Feldstärkekomparator FsK oder Multipathkomparator MpK kein Empfangssignal detektiert. Auf diese Art und Weise wird dem Mikroprozessor µP sofort mitgeteilt, ob ein Empfangssignal vorliegt. Dadurch, daß der Mikroprozessor µP den Bereich win vorgibt, innerhalb dessen die Zwischenfrequenz liegen muß, und die Sollwerte in Form eines seriellen Datenworts DIN vorgibt, mit denen der Feldstärkekomperator FsK und der Multipathkomparator MpK das Feldstärkesignal Fs beziehungsweise das Multipathsignal Mp vergleichen, können diese drei Detektoren jeweils einzeln gewichtet werden. Dadurch ist ihr Einfluß auf die Suchgenauigkeit schnell, einfach und präzise beeinflußbar. In einer Umgebung mit schlechter Empfangscharakteristik können die Sollwerte für die Feldstärke und das Multipathsignal herabgesetzt werden, so daß dadurch eine Anpassung an die Umgebungsbedingungen möglich ist. Würden die Sollwerte für das Feldstärkesignal Fs und das Multipathsignal Mp durch das serielle Datenwort DIN auf 0 gesetzt werden, so würden die beiden Komponenten Feldstärkekomperator FsK und Multipathkomparator MpK quasi abgeschaltet, so daß nurmehr der Zwischenfrequenz-Zähler ZF zur Bestimmung der Detektion eines Empfangssignals dient.

Selbstverständlich ist die erfindungsgemäße Schaltungsanordnung nicht auf 7 Bit breite Datenwörter Res0, Res1, 1a0-6 und la8-14 beschränkt. Vielmehr können die Datenworte in ihrer Breite bedarfsabhängig gewählt werden.

Vorteilhafterweise ist durch die Erfindung eine Verknüpfung von Feldstärke-, Multipath- und Zwischenfrequenzmessung derart möglich, daß mittels eines einzigen Bits und somit durch einen einzigen Pin (Gehäuseanschluß) angezeigt werden kann, ob ein zu einem Sender gehöriges Empfangssignal vorliegt.

Die beiden Analog-Digital-Wandler (ADW1 und ADW2) können durch einen Zweikanal-7-Bit-Analog-Digital-Wandler realisiert sein, wobei für den ersten Kanal das Feldstärkesignal Fs als Eingangssignal und für den zweiten Kanal das Multipathsignal Mp als Eingangssignal verwendet wird.

Beim Stand der Technik werden für die Feldstärke, das Multipathsignal oder die S-Kurve meist analoge Auswertungen vorgenommen. Die Analogsignale werden hierzu dem Mikroprozessor zugeführt und dort gewandelt. Das führt dazu, daß zusätzliche Leitungen mit den Analogsignalen zum Mikroprozessor geführt werden müssen. Erfolgt die Wandlung der Analogsignale bevor sie dem Mikroprozessor zugeführt werden, so sind die vorab erzeugten digitalen Worte dem Mikroprozessor per Bus zu übermitteln, was zu einem regen Datenverkehr zwischen der vorgeschalteten Schaltung und dem Mikroprozessor führt und den Mikroprozessor zusätzlich mit der Datenübertragung und Auswertung belastet. Zudem werden dadurch Störsignale erzeugt.

Neben der Auswertung der Zwischenfrequenz fZF, der Feldstärke Fs und des Multipathsignals Mp besteht zudem auf einfache Art und Weise die Möglichkeit, den Nulldurchgang der S-Kurve (= FM - demoduliertes Signal) auszuwerten und ebenfalls dem UND-Gatter AND zuzuführen.

Im Zwischenfrequenz-Zähler ZFZ wird innerhalb einer definierten Zeit eine bekannte Eingangsfrequenz gezählt und entsprechend ausgewertet. Das Ergebnis zeigt an, ob die Zwischenfrequenz (fZF = fOsz - fE) innerhalb des vorgesehenen Bereichs (Fensters) win liegt. Die Zählzeit, die Mittenfrequenz der zu bewertenden ZF-Frequenz und der Bereich win sind unabhängig voneinander einstellbar. Liegt die gemessene Zwischenfrequenz fZF innerhalb des Fensters win, so liegt am Ausgang des Zwischenfrequenz-Zählers ZFZ der entsprechende Zustand des ersten Suchlaufstoppsignals cent an. Liegt die gemessene Zwischenfrequenz fZF außerhalb des Fensters win, so liegt am Ausgang des Zwischenfrequenz-Zählers ZFZ das erste Suchlaufstoppsignal cent mit dem zweiten logischen Zustand an. Zusätzlich kann der Zwischenfrequenz-Zähler ZFZ dazu verwendet werden, anzugeben, ob die zu bewertende Frequenz fZF zu hoch oder zu tief ist.

## Patentansprüche

1. Integrierte Schaltung zur Detektion eines Empfangssignals,
- mit einem Zwischenfrequenzdetektor (ZFZ), der, falls die Zwischenfrequenz (fZF) innerhalb eines bestimmten Bereichs (win) liegt, ein erstes Suchlaufstopsignal (cent) liefert,
- mit einem Feldstärkekomparator (FsK), der, falls die Feldstärke (Fs) des Empfangesignals einen Feldstärkesollwert (la8-14) überschreitet, ein zweites Suchlaufstopsignal (Fsc) liefert,
- mit einem Multipathkomparator (MpK), der, falls ein Multipathsignal (Mp) einen bestimmten Multipathsollwert (la0-6) überschreitet, ein drittes Suchlaufstopsignal (Mpc) liefert,
- mit einer Verküpfungeeinrichtung (AND), die die drei Suchlaufstopsignale (cent, Fsc, Mpc) logisch miteinander zu einem binären Stopsignal (sstop) verknüpft, welches statisch am Ausgang der Verknüpfungseinrichtung (AND) anliegt und einem Mikroprozessor (µP) als dessen Eingangssignal zur Verfügung steht,
- mit einem ersten Analog-Digital-Wandler (ADW1), der dem Feldstärkekomparator (FsK) vorgeschaltet ist und zur Digitalisierung des Feldstärkesignals (Fs) dient,
- mit einem ersten Seriell-Parallel-Umsetzter (SR1), der zwischen den ersten Analog-Digital-Wandler (ADW1) und den Feldstärkekomparator (FsK) geschaltet ist,
- mit einem zweiten Analog-Digital-Wandler (ADW2), der dem Multipathkomparator (MpK) vorgeschaltet ist und zur Digitalisierung des Multipathsignals (Mp) dient, und
- mit einem zweiten Seriell-Parallel-Umsetzter (SR2), der zwischen den zweiten Analog-Digital-Wandler (ADW2) und den Multipathkomparator (MpK) geschaltet ist.

2. Integrierte Schaltung nach Anspruch 1,
bei der der Feldstärkesollwert (la8-14) und der Multipathsollwert (la0-6) in empfangsschwachen Gebieten auf niedrigere Werte als in empfangs starken Gebieten gesetzt sind.

3. Integrierte Schaltung nach Anspruch 2,
bei der die Bestimmung des Feldstärkesollwerts (1a8-14), des Multipathsollwerts (1a0-6) und des Bereichs (win), innerhalb dessen die Zwischenfrequenz (fZF) liegen soll, durch den Mikroprozessor (µP) erfolgt.

4. Integrierte Schaltung nach einem der Ansprüche 1 bis 3, mit einem dritten Seriell-Parallel-Umsetzer (SR3), dem der Feldstärkesollwert (1a8-14) und der Multipathsollwert (1a0-6) seriell zuführbar sind und der ausgangsseitig mit dem Feldstärkekomparator (FsK) und dem Multipathkomparator (MpK) gekoppelt ist.

5. Schaltungsanordnung, umfassend eine integrierte Schaltung nach einem der Ansprüche 1 bis 4 und einen Mikroprozessor (µP), bei der die integrierte Schaltung einen Ausgangsanschluß für das binäre Stopsignal (sstop) aufweist, der mit einem eine einzige Leitung umfassenden Eingangsanschluß des Mikroprozessors (µP) verbunden ist und bei der der Mikroprozessor (µP) mindestens einen Ausgangsanschluß aufweist, der mit mindestens einem Eingangsanschluß der integrierten Schaltung verbunden ist, um darüber den Feldstärkesollwert (la8-14) und den Multipathsollwert (1a0-6) als seriellen Datenwort und den Bereich (win), innerhalb dessen die Zwischenfrequenz (fZF) liegen soll, zu übertragen.

## Claims

1. Integrated circuit for detecting a received signal,
- having an intermediate frequency detector (ZFZ) which supplies a first search run stop signal (cent) if the intermediate frequency (fZF) lies within a specific range (win),
- having a field-strength comparator (FsK) which supplies a second search run stop signal (Fsc) if the field strength (Fs) of the received signal exceeds a field-strength setpoint value (1a8-14),
- having a multipath comparator (MpK) which supplies a third search run stop signal (Mpc) if a multipath signal (Mp) exceeds a specific multipath setpoint valve (1a0-6),
- having a logic component (AND) which logically combines the three search run stop signals (cent, Fsc, Mpc) with one another to form a binary stop signal. (sstop) which is statically present at the output of the logic element (AND) and is made available to a microprocessor (µP) as its input signal,
- having a first analog/digital converter (ADW1) which is connected upstream of the field-strength comparator (FsK) and serves to digitize the field strength signal (Fs),
- having a first serial/parallel converter (SR1) which is connected between the first analog/digital converter (ADW1) and the field-strength comparator (FsK),
- having a second analog/digital converter (ADW2) which is connected upstream of the multipath comparator (MpK) and serves to digitize the multipath signal (Mp), and
- having a second serial/parallel converter (SR2) which is connected between the second analog/digital converter (ADW2) and the multipath comparator (MpK).

2. Integrated circuit according to Claim 1, in which the field strength setpoint valve (1a8-14) and the multipath setpoint value (1a0-6) are set to lower values in ranges with weak reception than in ranges with strong reception.

3. Integrated circuit according to Claim 2, in which the field strength setpoint valve (1a8-14), the multipath setpoint value (1a0-6) and the range (win) within which the intermediate frequency (fZF) is to lie are determined by the microprocessor (µP).

4. Integrated circuit according to one of Claims 1 to 3, having a third serial/parallel converter (SR3) to which the field-strength setpoint value (1a8-14) and the multipath setpoint value (1a0-6) can be fed serially and which is coupled at the output end to the field-strength comparator (FsK) and to the multipath comparator (MpK).

5. Circuit arrangement comprising an integrated circuit according to one of Claims 1 to 4 and a microprocessor (µP), in which the integrated circuit has an output terminal for the binary stop signal (sstop) which is connected to an input terminal of the microprocessor (µP) which comprises a single line, and in which the microprocessor (µP) has at least one output terminal which is connected to at least one input terminal of the integrated circuit in order to transmit over it the field strength setpoint value (1a8-14) and the multipath setpoint value (1a0-6) as serial data word, and the range (win) within which the intermediate frequency (fZF) is to lie.

## Revendications

1. Circuit intégré pour détecter un signal de réception
• ayant un détecteur de fréquence intermédiaire (ZFZ) qui délivre un premier signal d'arrêt de recherche (cent) si la fréquence intermédiaire (fZF) se trouve à l'intérieur d'une plage (win) donnée,
• ayant un comparateur d'intensité de champ (FsK) qui délivre un deuxième signal d'arrêt de recherche (Fsc) si l'intensité de champ (Fs) du signal de réception dépasse une valeur de consigne pour l'intensité de champ (1a8-14),
• ayant un comparateur de trajets multiples (MpK) qui délivre un troisième signal d'arrêt de recherche (Mpc) si un signal par trajets multiples (Mp) dépasse une valeur de consigne pour les trajets multiples (1a0-6) donnée,
• ayant un élément de combinaison logique (AND) qui combine les trois signaux d'arrêt de recherche (cent, Fsc, Mpc) logiquement les uns aux autres pour former un signal d'arrêt (sstop) binaire qui existe statiquement à la sortie de l'élément de combinaison logique (AND) et est mis à disposition d'un microprocesseur (µP) en tant que son signal d'entrée,
• ayant un premier convertisseur analogique-numérique (ADW1) qui est monté en amont du comparateur d'intensité de champ (FsK) et qui sert à numériser le signal d'intensité de champ (Fs),
• ayant un premier convertisseur série-parallèle (SR1) qui est monté entre le premier convertisseur analogique-numérique (ADW1) et le comparateur d'intensité de champ (FsK),
• ayant un deuxième convertisseur analogique-numérique (ADW2) qui est monté en amont du comparateur de trajets multiples (MpK) et qui sert à numériser le signal par trajets multiples (Mp) et
• ayant un deuxième convertisseur série-parallèle (SR2) qui est monté entre le deuxième convertisseur analogique-numérique (ADW2) et le comparateur de trajets multiples (MpK).

2. Circuit intégré selon la revendication 1 pour lequel la valeur de consigne pour l'intensité de champ (1a8-14) et la valeur de consigne pour trajets multiples (1a0-6) sont réglées à des valeurs plus basses dans des domaines à faible réception que dans des domaines à forte réception.

3. Circuit intégré selon la revendication 2 pour lequel la détermination de la valeur de consigne pour l'intensité de champ (1a8-14), de la valeur de consigne pour trajets multiples (1a0-6) et de la plage (win) à l'intérieur de laquelle la fréquence intermédiaire (fZF) doit se trouver est effectuée par le microprocesseur (µP).

4. Circuit intégré selon l'une des revendications 1 à 3 avec un troisième convertisseur série-parallèle (SR3) auquel on peut conduire en série la valeur de consigne pour l'intensité de champ (1a8-14) et la valeur de consigne pour trajets multiples (1a0-6) et qui du côté sortie est couplé avec le comparateur d'intensité de champ (FaK) et avec le comparateur de trajets multiples (MpK).

5. Montage qui comprend un circuit intégré selon l'une des revendications 1 à 4 et un microprocesseur (µP), pour lequel le circuit intégré présente une borne de sortie pour le signal d'arrêt (sstop) binaire laquelle est reliée à une borne d'entrée - qui comprend un seul câble - du microprocesseur (µP) et pour lequel le microprocesseur (µP) présente au moins une borne de sortie qui est reliée à au moins une borne d'entrée du circuit intégré afin de transmettre grâce à lui la valeur de consigne pour l'intensité de champ (1a8-14) et la valeur de consigne pour trajets multiples (1a0-6) en tant que mot de donnée sériel et la plage (win) à l'intérieur de laquelle doit se trouver la fréquence intermédiaire (fZF).
